# EUROPÄISCHE PATENTSCHRIFT

(11) **EP 0 994 559 B1**
(45) Veröffentlichungstag und Bekanntmachung des Hinweises auf die Patenterteilung: **19.07.2017**
(21) Anmeldenummer: 99119745.0
(22) Anmeldetag: 06.10.1999
(51) Int. Cl.: H02M 7/48, H05K 1/14, H02M 7/00, H05K 7/14

(54) **Umrichter**
Converter
Convertisseur

(30) Priorität: 16.10.1998 DE 19847789
(43) Veröffentlichungstag der Anmeldung: 19.04.2000
(73) Patentinhaber: SEW-EURODRIVE GmbH & Co. KG, 76646 Bruchsal (DE)
(72) Erfinder: Roth-Stielow, Jörg, Dr., 75015 Bretten (DE); Schmidt, Joseph, 76675 Graben-Neudorf (DE)

(56) Entgegenhaltungen:
- EP-A- 0 688 092
- EP-A- 0 700 147
- DE-A1- 4 008 419
- US-A- 5 497 289
- US-A- 5 699 609
- US-A- 5 764 023
- PATENT ABSTRACTS OF JAPAN, Band 9411, Nr. 02, 31. MÛrz 1995; & JP 06 311760 A (HITACHI LTD.) 04. November 1994,
- PATENT ABSTRACTS OF JAPAN, Band 9612, Nr. 04, 30. April 1997; & JP 08 331865 A (MATSUSHITA ELECTRIC IND. CO. LTD.) 13. Dezember 1996,

## Beschreibung

Die Erfindung betrifft eine Umrichter-Baureihe, bestehend aus Umrichtern.

Umrichter sind beispielsweise aus dem Buch 'Frequenzumformer, Verlag Moderne Industrie, 1989, ISBN 3-478-93036-7'. Ein Umrichter umfasst einen Gleichrichter, der den Wechselstrom, beispielsweise Drehstrom, in eine Gleichspannung, die sogenannte Zwischenkreisspannung, umwandelt. Diese versorgt die sogenannte Endstufe, die aus der Gleichspannung eine im Idealfall sinusförmige Wechselspannung höherer Frequenz generiert. Mit dieser Wechselspannung wird eine Last, beispielsweise ein Elektromotor, versorgt. Der Umrichter umfasst weiterhin eine Steuerungsschaltung, die die Endstufe ansteuert, gegebenenfalls Messmittel und Sensoren für Strom- und/oder Spannungsmessung enthält und ein Steuer- und Regelverfahren für den Elektromotor, meist in Form von Software, enthält.

Dabei werden für jeweils verschiedene Elektromotoren verschiedene Steuer- und Regelverfahren angewendet. Oft verwendete Elektromotoren sind Asynchronmotoren oder Synchronmotoren. Ebenso sind Gleichstrommotoren, Reluktanzmotoren und bürstenlose Wechselspannungs-Motoren im Einsatz.

Bei Synchronmotoren werden Steuerverfahren eingesetzt, die nicht nur den Messwert der Zwischenkreisspannung, sondern auch die Messwerte der motorseitigen Ströme von der Endstufe zum Elektromotor hin berücksichtigen. Bei Asynchronmotoren sind ähnliche Steuerverfahren bekannt. Ebenso gibt es aber auch Steuerverfahren, die ohne den Messwert der Ströme auskommen. Bei manchen Steuerverfahren wird die Zwischenkreisspannung und / oder die motorseitige Ausgangsspannung gemessen und berücksichtigt.

Oft wird zur Erhöhung der Genauigkeit und Dynamik ein Sensor zur Winkelerfassung des Rotors des Motors oder ein entsprechender, zum Drehwinkel proportionaler linearer Messwert aus der Maschine oder Anlage verwendet. Solche Messwerte bzw. Informationen müssen der Steuerungsschaltung zugeführt werden, um von dem Steuerungsverfahren berücksichtigt zu werden. Als Ausführungsformen sind Resolver und Inkrementalgeber bekannt, die analoge oder digitale Messwerte an die Steuerungsschaltung liefern.

Es gibt jedoch auch Steuerverfahren ohne Sensor zur Winkelerfassung des Rotors des Motors oder entsprechenden linearen Messwert.

Die Umrichter werden eingesetzt in verschiedenen Anlagen oder Maschinen mit einer Mehrzahl anderer Umrichter oder weiterer Geräte. Meist gibt es eine übergeordnete Steuerungsanlage, die die Umrichter oder weiteren Geräte ansteuert und dazu mit diesen durch spezielle Leitungen verbunden ist. Im einfachsten Fall werden über binäre Spannungszustände die Umrichter und Geräte ein- und ausgeschaltet.

In vielen Anwendungen werden jedoch leistungsfähige Bussystem installiert, die Daten und Informationen von allen und zu allen verdrahteten Geräten transportieren können. Dem Fachmann bekannt sind Bussysteme, insbesondere Feldbussysteme wie INTERBUS, PROFIBUS, DeviceNet, CAN-Bus, ASI etc.. Je nach Bussystem werden verschiedene Anschlusstechniken verwendet, beispielsweise Steckverbinder mit verschiedener Polzahl.

Bei manchen Anwendungen werden Sensoren und Aktoren nicht nur an Bussysteme, sondern auch direkt an den Umrichter angeschlossen. Beispielsweise können Näherungsgeber zur Notabschaltung in dieser Weise angeschlossen werden.

Bei einigen Anwendungen werden Umrichter über eine Schnittstelle miteinander verbunden. Beispielsweise sind dadurch schnelle elektronische Achskopplungen möglich. Für andere Anwendungen oder auch Geräte sind weitere Schnittstellen nötig. Beispielsweise können Schnittstellen für Service-Computer vorhanden sein zum Einrichten und Einstellen von Parametern oder zur Beobachtung physikalischer oder mathematischer Größen des Steuerverfahrens für den Elektromotor.

Die vorgenannte Vielfalt von Applikationen erfordert je nach Applikation verschiedene Platinen der Steuerungsschaltung und eine verschiedene Anzahl von Anschlusseinrichtungen, beispielsweise von Steckverbindern oder von verschiedenen oder gleichartigen Steckern und Buchsen. Je nach Leistung des Elektromotors sind zusätzlich verschiedene Baugrößen mit verschiedenen Leistungen oder Leistungsgrößen zu fertigen und einzusetzen.

Die Umrichter-Baureihe umfasst alle Umrichter, die erstellt werden können. Die Variantenvielfalt an möglichen Umrichtern ist äußerst groß. Daher werden von jeder Variante nur eine kleine Stückzahl gefertigt, weshalb damit ein hoher Aufwand und hohe Kosten verbunden sind.

Bei Austausch eines defekten Umrichters im Feld, also in der Anlage oder Maschine, ist ein großer Montageaufwand nötig, da für die Entfernung des alten Gerätes alle Verdrahtungen gelöst werden müssen und dann das neue Gerät neu verdrahtet werden muss, insbesondere mit allen Bussystemen, Sensoren, Aktoren und den Leistungskabeln. Ein beachtlicher Arbeitsaufwand ist auch erforderlich für das Lösen des Kabel-Schirmes.
Ebenso gibt es den Fall, dass beispielsweise beim Einrichten von Maschinen oder Anlagen ein Umrichter probeweise eingesetzt wird. Nach dem Probelauf kann sich herausstellen, dass ein anderes Steuerverfahren, beispielsweise mit oder ohne Sensor zur Winkelerfassung, ein günstigeres Betriebsverhalten hat. Auch in diesem Fall muss der Umrichter ausgetauscht werden mit den gleichen vorgenannten Nachteilen.

Aus der US 5 699 609 A ist ein Herstellverfahren für eine Leistungselektronik gezeigt. Aus der US 5 764 023 A ist ein Umrichter für eine einzige Applikation gezeigt. Aus der US 5 497 289 A ist ein Umrichter mit kompaktem Design gezeigt. Aus der DE 40 08 419 A1 ist ein Stromrichterschrank bekannt.

Der Erfindung liegt die Aufgabe zugrunde, Fertigungskosten und Montageaufwand bei einem modular zusammengesetzten Umrichter zu verbessern und gleichzeitig adäquate Leistungsfähigkeit des Umrichters, insbesondere in Bezug auf seine Kühlfunktion, zu gewährleisten. Die Aufgabe wird gelöst nach den in Anspruch 1 angegebenen Merkmalen. Ein wesentliches Merkmal der Erfindung liegt im modularen Aufbau der Umrichter-Baureihe.

Dabei enthält das Leistungsmodul die Leistungselektronik, wie beispielsweise Gleichrichter und Endstufe, und wird je nach Größe des Elektromotors in verschiedenen Leistungsgrößen, also mit verschiedenen möglichen maximalen Ausgangsleistungen gefertigt.

Weiterhin enthält dabei der Steuerkopf mindestens eine Platine mit einer Steuerungsschaltung, die das Steuerverfahren in Form von Software und / oder Hardware umfasst. Je nach Applikation ist die Hardware und Software dieser Platine verschieden.

Das dritte Modul ist dabei die Anschlusseinheit, die Anschlusseinrichtungen je nach der benötigten Applikation für Bussysteme wie, Feldbussysteme wie Profibus, Interbus, CAN-Bus, DeviceNet, ASI oder andere, umfasst. Des weiteren umfasst sie je nach der benötigten Applikation Anschlusseinrichtungen für Winkelgeber, also Sensoren, die Information über die Winkellage des Rotors des vom Umrichter betriebenen Elektromotors ermöglichen. Darüber hinaus umfasst sie je nach der benötigten Applikation Anschlusseinrichtungen für serielle oder parallele Schnittstellen, beispielsweise für Wartungsgeräte, Computer oder Verbindungen und Kommunikationseinrichtungen zu anderen Umrichtern.

Durch die vorgenannte Aufteilung verschiedener Aufgaben in die drei vorgenannten Module, also Leistungsmodul, Steuerkopf und Anschlusseinheit, ist eine größere Stückzahl bei der Fertigung der jeweiligen Module möglich. Dies senkt die Fertigungskosten.

Für jede Applikation kann ein geeigneter Umrichter zusammengesetzt werden, der aus dem für die Applikation geeigneten Steuerkopf, dem geeigneten Leistungsmodul und der geeigneten Anschlusseinheit hergestellt ist. Gleichzeitig ist der modulare Aufbau des Umrichters von Vorteil beim Austausch von Geräten im Feld.

Ist beispielsweise der Steuerkopf defekt, müssen das Leistungsmodul und die Anschlusseinheit nicht ausgetauscht werden. Verdrahtungen müssen nicht gelöst und abgeschraubt werden. Das Lösen des Kabel-Schirmes ist nicht erforderlich, da der Kabel-Schirm an die Masseverbindung der Anschlusseinheit angeschlossen wird und die Masseverbindung zwischen der Anschlusseinheit und dem Steuerkopf beim

Zusammensetzen dieser beiden Module hergestellt wird. Der Arbeitsaufwand wird deutlich verringert. Dies alles vereinfacht und verbilligt den Austausch.

Ebenso ist von Vorteil, dass beispielsweise durch Austausch eines Steuerkopfes S_{b} gegen S_{f}, wobei b ≠ f ist, der Austausch eines Steuerverfahrens gegen ein anderes Steuerverfahren sehr schnell und einfach möglich ist. Beispielsweise wird ein Umrichter mit Winkelsensor betrieben und nach Austausch des Steuerkopfes ohne Winkelsensor, oder umgekehrt. Beim Einrichten der Anlage oder Untersuchungen der Anlage sind dadurch Vereinfachungen und Kosteneinsparungen erreichbar.

Bei einer Ausführungsform sind definierte Schnittstellen vorhanden, einerseits zwischen Steuerkopf und Anschlusseinheit und andererseits zwischen Steuerkopf und Leistungsmodul. Von Vorteil ist dabei, dass jeder Steuerkopf S_{f} an jedes Leistungsmodul Lᵢ und ebenso jeder Steuerkopf S_{f} an jede Anschlusseinheit Aₖ angeschlossen werden kann.

Diese definierten Schnittstellen ermöglichen einerseits mechanisch geführtes, passgenaues Einstecken und lösbares Befestigen der jeweiligen Module und andererseits das Schließen der elektrischen Verbindungen, insbesondere mit Steckverbindern. Von Vorteil ist definierte Schnittstelle, da sie ein Kompatibilität der gesamten Serie der Anschlusseinheiten zu der gesamten Serie der Steuerköpfe gewährleistet, entsprechendes gilt für die Schnittstelle zwischen Leistungsmodul und Steuerkopf. Beispielsweise passen zu einem Leistungsmodul Lᵢ der Baugröße Bᵢ alle Steuerköpfe.

Der Steuerkopf umfasst weiterhin eine Anschlusseinrichtung für ein Handbediengerät. Von Vorteil ist dabei beim Einrichten des Umrichters die einfache Eingabe von Parametern für das Steuerverfahren und die einfache Anzeige von Betriebsdaten und - zuständen des Umrichters mit Elektromotor.

Bei einer weiteren Ausgestaltung ist die Platine aller Anschlusseinheiten gleich, aber deren Bestückung verschieden. Von Vorteil ist dabei, dass nur die für die Applikation notwendigen Stecker und Buchsen montiert werden und somit Kosten und Fertigungszeit eingespart werden. Weiterhin sind Anschlusseinrichtungen für Sensoren zur Erfassung der Winkellage des Rotors des Motors vorhanden. Ebenso sind je nach Applikationen Anschlusseinrichtungen für Bussysteme, insbesondere Feldbusse wie INTERBUS, PROFIBUS, CAN-Bus, vorhanden. Weiterhin sind serielle oder parallele Schnittstellen, insbesondere für Computer und ähnliche Geräte, vorhanden. Von Vorteil ist dabei, dass für die vorgenannten Fälle je nach Applikation die Platine der Anschlusseinheit nur mit der Anschlusseinrichtung, insbesondere Steckverbinder, bestückt wird, die benötigt wird. Damit sind Kosteneinsparungen und Verringerung der Fertigungszeit verbunden.

Bei einer weiteren Ausführungsform ist ein Steckverbinder zur Bildung der elektrischen Schnittstelle zwischen Steuerkopf und Leistungsmodul vorhanden. Von Vorteil ist dabei, dass immer der gleiche Steckverbinder vorhanden ist und daher alle Steuerköpfe auf alle Leistungsmodule passen. Weiterhin ist ein Erdungsblech vorhanden. Von Vorteil ist dabei, dass eine Masseverbindung zum Steuerkopf hin entsteht. Von dieser ausgehend wird wiederum eine Masseverbindung geschaffen werden zur Anschlusseinheit. Daher ist es in vorteilhafter Weise möglich, durch bloßes mechanisches Zusammensetzen der drei Module eine Masseverbindung zu schaffen, ohne dass bei Austausch des Steuerkopfes der Schirm eines Kabels gelöst und neu verbunden werden muss. Weiterhin übernimmt dieses Erdungsblech auch eine Kühlfunktion für mindestens ein Bauelement der Platine des Steuerkopfes. Dies verringert natürlich die Fertigungskosten und vermindert den Montageaufwand.

Bei einer weiteren erfindungsgemäßen Ausgestaltung ist ein Netzgerät zur Versorgung der elektronischen Schaltung auf der Platine des Steuerkopfes vorhanden. Es kann beispielsweise aus der Zwischenkreisspannung die nötige oder nötigen Gleichspannungen zur Verfügung stellen.

Für einen möglicherweise gewünschten Stand-by Betrieb kann aber auch eine 24V Versorgung von extern zur Spannungsversorgung der elektronischen Schaltung verwendet werden. Diese 24V Versorgung wird über die Steckverbinder 29 und 34 von der Anschlusseinheit geliefert. Der Anschluss für die externen Drähte ist bei den Klemmen 38 möglich.

Die Erfindung wird anhand von Abbildungen näher erläutert.

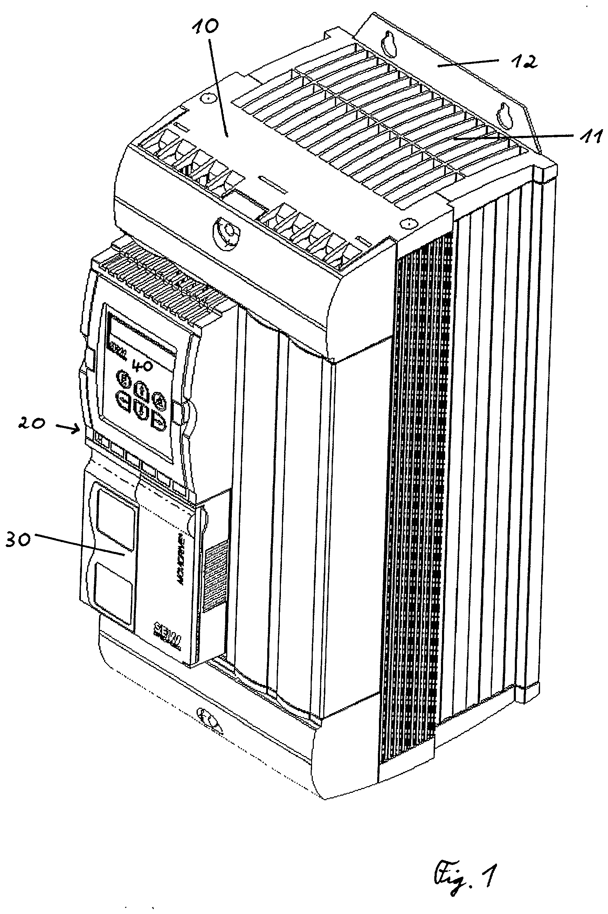

In der Figur 1 ist ein Umrichter der erfindungsgemäßen Umrichter-Baureihe gezeigt. Dabei wurde eine größere Leistungsgröße eines Leistungsmoduls 10 gewählt. Ein Steuerkopf 20 wird auf das Leistungsmodul 10 gesteckt und ist vom Leistungsmodul 10 umgeben.

Ein Montageblech 12 dient zur Befestigung des Umrichters, beispielsweise im Schaltschrank. Lüftungsschlitze 11 dienen zur konvektiven Kühlung von Bauelementen des Leistungsmoduls10. Beispielsweise sind dabei IGBT-Transistoren der Endstufe und der Gleichrichter die stärksten Wärmeerzeuger, die gekühlt werden müssen.

In der Figur 1 ist auch ein Handbediengerät 40 und ein Anschlusseinheit 30, die auf dem Steuerkopf 20 angebracht werden, gezeigt. Dieses Handbediengerät ermöglicht die Eingabe und das Überspielen von Daten, wie Parametern des Steuer- und Regelverfahrens, in den Steuerkopf. Beispielsweise sind bei Inbetriebnahme Parameterwerte einzustellen, die für den angesteuerten Elektromotor geeignet sind. Ein anderes Beispiel sind während des Betriebs die Änderung von Parametern wie die Drehzahl des Elektromotors oder dergleichen.

Bei anderen Leistungsmodulen kleinerer Leistungsgröße wird der Steuerkopf ebenfalls eingesteckt, jedoch ist das Leistungsmodul nur ein quaderähnliches Objekt, auf dessen Oberseite in diesem Fall der Steuerkopf sitzt.

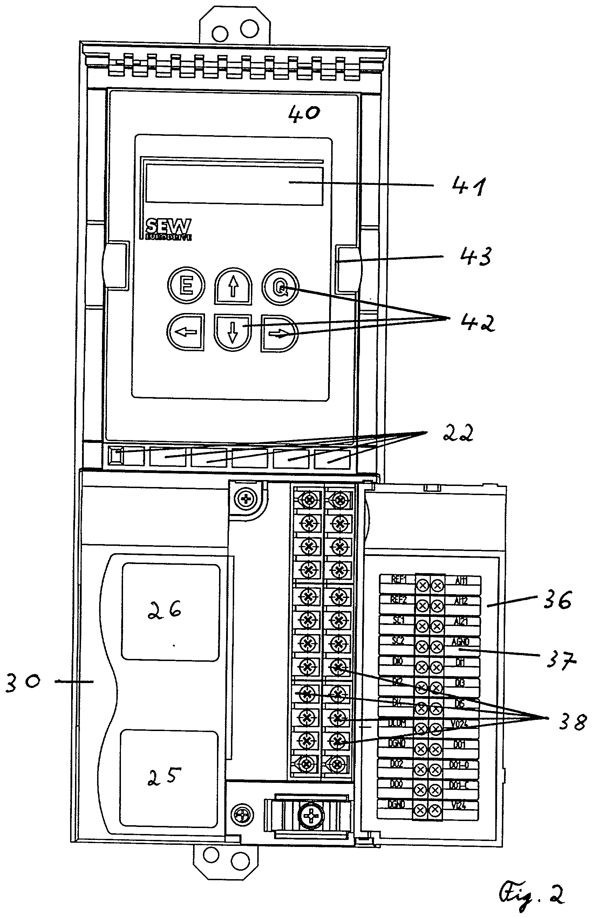

In der Figur 2 ist eine Vorderansicht des Steuerkopfes 20 zu sehen. Das Handbediengerät 40 wird mit einem mechanischen Einrastmechanismus 43 am Steuerkopf 20 befestigt. Dabei wird ein Stecker in eine Buchse an der Unterseite des Handbediengerätes 40 geführt. Dadurch werden die elektrischen Verbindungen geschlossen und gleichzeitig das Handbediengerät 40 und der Steuerkopf 20 mechanisch lösbar und fest verbunden.

Drucktasten 42 dienen zur Menusteuerung des Handbediengerätes 40. Parameterwerte und weitere Informationen werden am LCD-Display 41 angezeigt. Am Steuerkopf 20 sind auch Enden von Lichtleitern für LED-Anzeigen 22 gezeigt, die Statusanzeigen der Elektronik des Steuerkopfes 20 sind. Beispielsweise können Fehler angezeigt werden wie Spannungsausfälle, Kurzschlüsse, Störungen in der Kommunikation über Feldbus oder dergleichen.

Zusätzlich ist die Anschlusseinheit 30 mit offener Klapptüre 36 gezeigt. Eine Beschriftung 37 ist vom Bediener in einfacher Weise zuordenbar zu den Klemmen oder Klemmverbindern 38. Die Anschlusseinheit 30 wird beim Einstecken in den Steuerkopf 20 mechanisch geführt. Dabei werden wiederum die elektrischen Verbindungen zum Steuerkopf hin geschlossen.

Bereiche für Anschlusseinrichtungen für Feldbus 25 und Schnittstellen 26 oder Sensoren zur Erfassung des Winkels des Rotors des Motors, also Resolver oder Inkrementalgeber sind in der Figur 2 ebenfalls gezeigt.

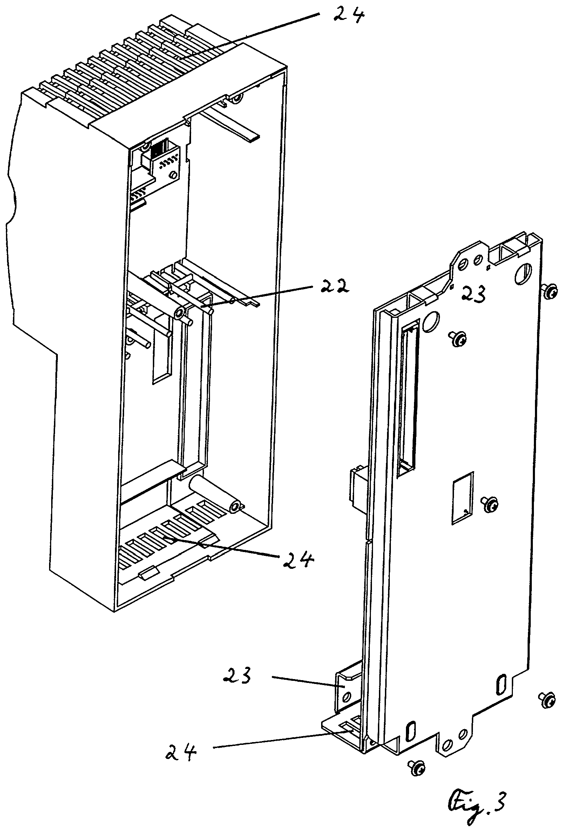

In der Figur 3 ist das Gehäuse eines offenen Steuerkopfes zu sehen. Lüftungsschlitze 24 ermöglichen eine konvektive Kühlung der Elektronik. Die Lichtleiter für LED-Anzeigen 22 leiten das Licht der LED-Anzeigen durch das Gehäuse des Steuerkopfes 20 hindurch zur Vorderfront.

Ein Erdungsblech 23 besitzt mechanische Gehäusefunktion, insbesondere bietet es eine stabile Montagefläche und Grundfläche. Gleichzeitig schirmt es die Elektronik des Steuerkopfes gegen Einstrahlungen vom Leistungsmodul her ab. Des weiteren ist es mit einer Zunge um die Ecken herumgebogen und kann nun Kühlfunktion für die Halbleiterbauelemente der Platine des Steuerkopfes übernehmen. Je nach Dimensionierung des Leistungsmoduls kann das Blech 23 auch eine gleichmäßigere Wärmeverteilung auf der Grundfläche des Steuerkopfes bewirken, also zur Kühlung oder Wärmeabfuhr des Leistungsmodules beitragen. Zusätzlich kann an das Erdungsblech 23 ein weiteres Blech 51 angeschraubt werden, das zur Anschlusseinheit 30 zugeordnet ist. Somit ist eine Masseverbindung zur Anschlusseinheit herstellbar.

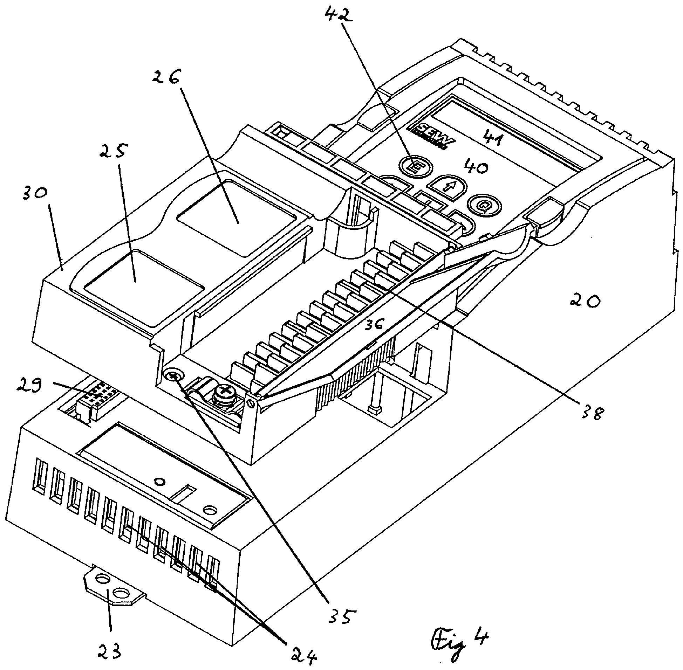

In der Figur 4 ist die Anschlusseinheit 30 leicht abgehoben dargestellt mit aufgeklappter Klapptüre 36. Somit sind die Befestigungsschraube 35 und die Klemmen 38 für Ein- und Ausgängen, also Anschließen von Sensoren und Aktoren zu sehen. Die Anschlusseinheit 30 hat Bereiche für Anschlusseinrichtungen für Feldbus 25 und Schnittstellen 26 oder Sensoren zur Erfassung des Winkels des Rotors des Motors, also Resolver oder Inkrementalgeber.

In der Figur 4 ist auch der Steckverbinder 29, der die elektrische Schnittstelle vom Steuerkopf 20 zur Anschlusseinheit 30 bildet, zu sehen.

In der Figur 5 ist als Explosionszeichnung noch die Platine der Anschlusseinheit 30 zu sehen. Sie trägt die Steckverbinderpositionen 39, die je nach Applikation jeweils bestückt oder unbestückt sind. Der Steckverbinder 34 wird in den Steckverbinder 29 eingesteckt und schafft somit die elektrischen Verbindungen.

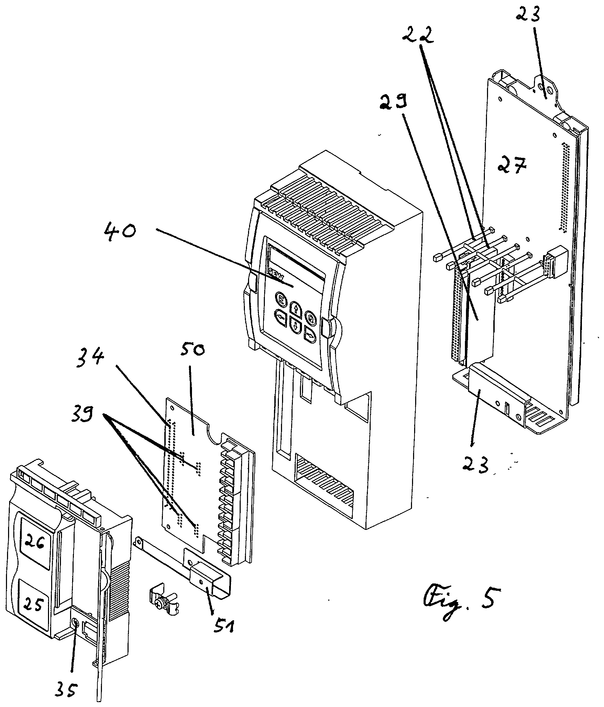

Ebenso ist in der Figur 5 das mit einer Zunge herumgebogene Erdungsblech zu sehen, das nicht nur mechanisch tragende Funktion sondern auch die Funktion der Masseverbindung hat. Die Lichtleiter 22 sind ebenfalls auf der Platine des Steuerkopfes gezeigt.

Das Blech 51 wird mit der Befestigungsschraube 35 an das Erdungsblech 23 angeschlossen und schafft somit eine Verbindung mit Masse. Das Lösen und wiederum Verbinden der Kabelschirme ist bei Austausch des Steuerkopfes nun nicht mehr nötig. Die Masseverbindung wird durch das Zusammenschrauben des Bleches 51 und des Erdungsbleches 23 geschaffen.

Dabei sind die Steckverbinder 29 und 34 für alle Steuerköpfe der Baureihe gleich. Ebenso sind die Positionen der Befestigungsschrauben und mechanischen Abmessungen der mechanischen Schnittstelle kompatibel. Auch das Erdungsblech kann somit seine elektrische Funktion der Masseverbindung erfüllen. Somit ist es möglich alle Module miteinander zu verbinden.

### Bezugszeichenliste

- 10: Leistungsmodul
- 11: Lüftungsschlitze
- 12: Montageblech
- 20: Steuerkopf
- 21: Platine mit elektronischen Elementen
- 22: Lichtleiter für LED-Anzeigen
- 23: Erdungsblech
- 24: Lüftungsschlitze
- 25: Bereich für Anschlusseinrichtungen für Feldbus
- 26: Bereich für Anschlusseinrichtungen für Schnittstellen, Winkelsensoren
- 27: Platine des Steuerkopfes
- 29: Steckverbinder
- 30: Anschlusseinheit
- 31: Platine
- 32: Steckverbinder
- 33: Steckverbinder
- 34: Steckverbinder
- 35: Befestigungsschraube
- 36: innen beschriftete Klapptüre
- 37: Beschriftung
- 38: Klemmen / Klemmverbinder
- 39: optionale Steckverbinderpositionen
- 40: Handbediengerät
- 41: LCD Display
- 42: Drucktasten
- 43: Einrastmechanismus
- 50: Platine der Anschlusseinheit
- 51: Blech

## Patentansprüche

1. Umrichter für einen Elektromotor aufweisend,
- Leistungselektronik und Anschlusseinrichtungen für Leistungskabel umfassendes Leistungsmodul Lᵢ (10),
- eine elektronische Schaltung umfassender Steuerkopf S_{f} (20), dessen Platine mit der elektronischen Schaltung ausgelegt ist für ein Steuer- und Regelverfahren mit oder ohne Sensor zur Winkelerfassung des Rotors des Elektromotors,
- und eine Platine umfassende Anschlusseinheit Aₖ (30)
wobei die Platine der Anschlusseinheit Aₖ Anschlusseinrichtungen für einen Sensor zur Winkelerfassung des Rotors des Elektromotors aufweist,
wobei die Platine der Anschlusseinheit Aₖ Anschlusseinrichtungen für eine serielle oder parallele Schnittstelle aufweist,
wobei der Umrichter das Leistungsmodul Lᵢ, den Steuerkopf S_{f} und die Anschlusseinheit Aₖ aufweist derart, dass der Umrichter modular zusammensetzbar und herstellbar ist, so dass das Leistungsmodul Lᵢ, der Steuerkopf S_{f} und die Anschlusseinheit Aₖ für das Steuer-und Regelverfahren geeignet ist,
wobei ein Handbediengerät (40) mittels eines mechanischen Einrastmechanismus (43) am Steuerkopf (20) befestigt ist,
wobei ein Stecker in eine Buchse an der Unterseite des Handbediengerätes (40) geführt ist, so dass eine elektrischen Verbindungen geschlossen und gleichzeitig das Handbediengerät (40) mit dem Steuerkopf (20) mechanisch lösbar und fest verbunden wird, wobei ein Erdungsblech (23) derart ausgebildet ist, daß dieses Erdungsblech vom Leistungsmodul Lᵢ zum Steuerkopf S_{f} eine elektrische Masseverbindung darstellt, wobei das Erdungsblech (23) derart ausgebildet ist, daß es eine Kühlfunktion für mindestens ein Bauelement der Platine des Steuerkopfes S_{f} erfüllt.

2. Umrichter nach Anspruch 1,
**dadurch gekennzeichnet, dass**
die Platine der Anschlusseinheit Aₖ Anschlusseinrichtungen für ein oder mehrere Feldbussysteme besitzt.

3. Umrichter nach einem der vorangegangenen Ansprüche,
**dadurch gekennzeichnet, dass**
der Steuerkopf S_{f} mindestens einen Steckverbinder aufweist, der die elektrische Schnittstelle zur Anschlusseinheit Aₖ und / oder zum Leistungsmodul Lᵢ bildet.

4. Umrichter nach einem der vorangegangenen Ansprüche,
**dadurch gekennzeichnet, dass**
die Platine des Steuerkopfes S_{f} ein Netzgerät zur Versorgung der elektronischen Schaltung der Platine des Steuerkopfes S_{f} trägt.

5. Umrichter nach einem der vorangegangenen Ansprüche,
**dadurch gekennzeichnet, dass**
die Platine des Steuerkopfes S_{f} Lumineszenzdioden zum Anzeigen aufweist, wobei an den Lumineszenzdioden Lichtleiter für LED-Anzeigen positioniert sind und der Steuerkopf S_{f} derart ausgebildet ist, dass er ein Gehäuse aufweist, und die Lichtleiter (22) durch das Gehäuse des Steuerkopfes S_{f} geführt sind.

6. Umrichter nach einem der vorangegangenen Ansprüche,
**dadurch gekennzeichnet, dass**
der Steuerkopf S_{f} Lüftungsschlitze (24) zur konvektiven Kühlung der elektronischen Schaltung aufweist.

7. Umrichter nach einem der vorangegangenen Ansprüche,
**dadurch gekennzeichnet, dass**
das Leistungsmodul Lüftungsschlitze zur konvektiven Kühlung der Leistungselektronik aufweist.

## Claims

1. Converter for an electric motor having,
- power electronics and connection devices for power module Lᵢ (10) comprising power cable,
- a control head S_{f} (20) comprising an electronic circuit, the circuit board of which control head with the electronic circuit is designed for a control and regulating method with or without sensor for angle detection of the rotor of the electric motor,
- and a connection unit Aₖ (30) comprising a circuit board
wherein the circuit board of the connection unit Aₖ has connection devices for a sensor for angle detection of the rotor of the electric motor,
wherein the circuit board of the connection unit Aₖ has connection devices for a serial or parallel interface,
wherein the converter has the power module Lᵢ, the control head S_{f} and the connection unit Aₖ in such a way that the converter can be assembled and produced modularly, so that the power module Lᵢ, the control head S_{f} and the connection unit Aₖ is suitable for the control and regulating method,
wherein a manual operating unit (40) is fastened to the control head (20) by means of a mechanical latching mechanism (43),
wherein a plug is led into a socket at the underside of the manual operating unit (40), so that an electrical connection is made and at the same time the manual operating unit (40) is mechanically releasably and fixedly connected to the control head (20),
wherein an earthing plate (23) is configured in such a way that said earthing plate constitutes an electrical earth connection from the power module Lᵢ to the control head S_{f}, wherein the earthing plate (23) is configured in such a way that a cooling function for at least one component of the circuit board of the control head S_{f} is fulfilled.

2. Converter according to Claim 1,
**characterised in that**
the circuit board of the connection unit Aₖ has connection devices for one or more fieldbus systems.

3. Converter according to one of the preceding claims, **characterised in that**
the control head S_{f} has at least one plug connector which forms the electrical interface with the connection unit Aₖ and/or with the power module Li.

4. Converter according to one of the preceding claims, **characterised in that**
the circuit board of the control head S_{f} carries a power supply unit for supplying the electronic circuit of the circuit board of the control head S_{f}.

5. Converter according to one of the preceding claims, **characterised in that**
the circuit board of the control head S_{f} has light emitting diodes for displaying, light guides for LED displays being positioned on the light emitting diodes, and the control head S_{f} being configured in such a way that it has a housing, and the light guides (22) are led through the housing of the control head S_{f}.

6. Converter according to one of the preceding claims, **characterised in that**
the control head S_{f} has ventilation slots (24) for convective cooling of the electronic circuit.

7. Converter according to one of the preceding claims, **characterised in that**
the power module has ventilation slots for convective cooling of the power electronics.

## Revendications

1. Variateur pour un moteur électrique, présentant
- un module de puissance Lᵢ (10) comprenant une électronique de puissance et des dispositifs de connexion pour des câbles de puissance,
- une tête de commande S_{f} (20) comprenant un circuit électronique, dont la platine avec le circuit électronique est conçue pour un procédé de commande et de régulation avec ou sans capteur de détection d'angle du rotor du moteur électrique,
- et une unité de connexion Aₖ (30) comprenant une platine,
la platine de l'unité de connexion Aₖ présentant des dispositifs de connexion pour un capteur de détection d'angle du rotor du moteur électrique,
la platine de l'unité de connexion Aₖ présentant des dispositifs de connexion pour une interface série ou parallèle,
le variateur présentant le module de puissance Lᵢ, la tête de commande S_{f} et l'unité de connexion Aₖ de façon que le variateur puisse être assemblé et fabriqué de manière modulaire afin que le module de puissance Lᵢ, la tête de commande S_{f} et l'unité de connexion Aₖ soient adaptés pour le procédé de commande et de régulation,
un appareil à commande manuelle (40) étant fixé sur la tête de commande (20) au moyen d'un mécanisme d'encliquetage mécanique (43),
une fiche étant guidée dans une douille sur la face inférieure de l'appareil à commande manuelle (40) afin de fermer une liaison électrique et réaliser en même temps une liaison mécanique détachable et ferme de l'appareil à commande manuelle (40) avec la tête de commande (20),
une tôle de mise à la terre (23) étant réalisée de façon que cette tôle de mise à la terre constitue une connexion de masse électrique entre le module de puissance Lᵢ et la tête de commande S_{f},
la tôle de mise à la terre (23) étant réalisée de façon à remplir une fonction de refroidissement pour au moins un composant de la platine de la tête de commande S_{f}.

2. Variateur selon la revendication 1,
**caractérisé en ce que**
la platine de l'unité de connexion Aₖ possède des dispositifs de connexion pour un ou plusieurs systèmes de bus de terrain.

3. Variateur selon l'une des revendications précédentes,
**caractérisé en ce que**
la tête de commande S_{f} présente au moins un connecteur qui forme l'interface électrique avec l'unité de connexion Aₖ et/ou le module de puissance Lᵢ.

4. Variateur selon l'une des revendications précédentes,
**caractérisé en ce que**
la platine de la tête de commande S_{f} porte une unité d'alimentation pour alimenter le circuit électronique de la platine de la tête de commande S_{f}.

5. Variateur selon l'une des revendications précédentes,
**caractérisé en ce que**
la platine de la tête de commande S_{f} présente des diodes luminescentes pour l'affichage, des guides de lumière pour afficheurs à LED étant positionnés sur les diodes luminescentes et la tête de commande S_{f} étant réalisée de façon à présenter un boîtier et les guides de lumière (22) étant conduits à travers le boîtier de la tête de commande S_{f}.

6. Variateur selon l'une des revendications précédentes,
**caractérisé en ce que**
la tête de commande S_{f} présente des fentes de ventilation (24) pour le refroidissement par convection du circuit électronique.

7. Variateur selon l'une des revendications précédentes,
**caractérisé en ce que**
le module de puissance présente des fentes de ventilation pour le refroidissement par convection de l'électronique de puissance.
